# EUROPEAN PATENT APPLICATION

(11) **EP 4 576 214 A1**
(43) Date of publication of application: **25.06.2025**
(21) Application number: 24214373.3
(22) Date of filing: 21.11.2024
(51) Int. Cl.: H01L 25/075, H10H 29/80, H10H 29/852, H10H 29/855

(54) **DISPLAY DEVICE HAVING A SEMICONDUCTOR LIGHT-EMITTING DEVICE AND MANUFACTURING FOR A DISPLAY DEVICE HAVING A SEMICONDUCTOR LIGHT-EMITTING DEVICE**

(30) Priority: 19.12.2023 KR 20230185852
(71) Applicant: LG Electronics Inc., Yeongdeungpo-gu Seoul 07336 (KR)
(72) Inventor: KIM, Jiweon, 06772 Seoul (KR); CHOI, Jeongsik, 06772 Seoul (KR); KIM, Kiseok, 06772 Seoul (KR); KIM, Juho, 06772 Seoul (KR)
(74) Representative: Vossius & Partner Patentanwälte Rechtsanwälte mbB

(57) **Abstract**

A display device including a semiconductor light-emitting device (110) according to an embodiment may include a wiring substrate (150), a semiconductor light-emitting device (110) disposed on the wiring substrate (150), a diffusion layer (165) disposed on the semiconductor light-emitting device and including a light scattering material, and a fist black layer structure (180) disposed on the diffusion layer (165) and including a transparent layer (182). The first black layer structure including the transparent layer may include one or more transparent layers (182a, 182b) between the plurality of black layers (181a, 181,b, 181c). The first black layer structure (180) including the transparent layer (182) may include a first black layer (181a), a first transparent layer (182a) disposed on the first black layer (181a), and a second black layer (181b) disposed on the first transparent layer (182a). The first black layer structure including the transparent layer may include a second transparent layer (182b) disposed on the second black layer (181b) and a third black layer (181c) disposed on the second transparent layer (182b).

## Description

An embodiment relates to a display device including a semiconductor light-emitting device.

Large-scale display devices include a liquid crystal display (LCD), an OLED display, and a Micro-LED display.

The Micro-LED display is a display that uses micro-LEDs which are semiconductor light-emitting devices with diameter or cross-sectional area of 100*µ*m or less, as a display device.

Since the Micro-LED display uses micro semiconductor light-emitting devices, as a display device, the Micro-LED display has an excellent performance in many characteristics such as a contrast ratio, a response speed, a color reproduction rate, a viewing angle, a brightness, a resolution, a life, a luminous efficiency or a luminance.

In particular, the micro-LED display has the advantage of being able to freely adjust the size and resolution and to implement a flexible display because the screen may be separated and combined in a modular way. Additionally, micro-LED displays are not only applied to TVs but also to a digital signage.

The Digital signage is a display installed inside and outside a building using a digital information display (DID), and is a device that provides images or videos containing advertisements or various information.

Types of digital signage include an outdoor digital signage and an indoor digital signage.

The outdoor digital signage refers to a digital signage installed on an exterior wall of buildings, electronic signboards, etc., or installed outside for outdoor cinema. The indoor digital signage refers to a digital signage installed on the inner wall of a large shopping mall or in the form of a signboard.

In the digital signage, micro-sized semiconductor light-emitting diodes LEDs may be used as display devices.

Meanwhile, the spectral characteristics of display devices such as digital signage may be expressed in the CIE 1976 Lu'v' color coordinate system. In the CIE 1976 Lu'v' color coordinate system, L represents brightness. If the value of L is 0, it represents black, and if the value of L is 100, it represents white.

Also, the value of u' indicates whether the color is biased toward red or green. If the value of u' is negative, the color is biased toward green, and if the value of u' value is positive, the color is biased toward red.

Also, the value of v' indicates whether the color is biased towards yellow or blue. If the value of v' is negative, the color is biased towards blue, and if the value of v' is positive, the color is biased towards yellow. The color viewing angle, which is the difference in color between white, may be expressed as △u'v' @±60°.

In the internal comparative technology, light scattering materials are used in the coating layer to improve the color difference between the whites of the Micro LED Display to improve the color viewing angle characteristics.

However, when light scattering materials are added to improve color viewing angle characteristics in digital signage, there is a problem of a white turbidity phenomenon where the light scattering materials clump together and appear white, which degenerates a black impression or a blackness of digital signage. Here, the `black impression' or 'blackness' refers to the value that may make black color close to the original color. The black impression may be expressed as a L (Brightness) value based on the color coordinate system, and the lower the L value, the better the black impression.

Meanwhile, according to internal comparative technology, a black film layer was placed on the coating layer to improve the black impression. However, since the black film layer of the internal technology itself has low adhesiveness, a separate adhesive layer such as OCA is to be interposed between the coating layer and the black film layer. But there is a problem in that the adhesive layers such as OCA have low optical transparency.

Also, according to internal comparative technology, before forming a black film layer on the coating layer, a grinding process is performed after the liquid coating layer has cured. However, since the grinding process may cause mechanical damage to the semiconductor light-emitting device, there is a problem in that the coating layer cannot be grounded below a predetermined thickness. Additionally, in order to secure a color viewing angle, there is a restriction in that a coating layer with light scattering materials dispersed therein is to be provided with a certain thickness on an upper side of the semiconductor light-emitting device. So, there is a problem in that the black impression may be deteriorated due to the presence of the coating layer with light scattering materials dispersed therein.

The present invention is specified by the independent claim. Preferred embodiments are defined by the dependent claims. One of the technical objects of the embodiment is to solve the problem that even though the diffusion layer in which the light scattering material is dispersed improves a color viewing angle characteristic, but the diffusion layer may cause a white turbidity phenomenon and reduce the black impression.

That is to say, the technical object of the embodiment is to provide a coating layer structure for a display device that may maintain or improve the black impression while improving color viewing angle characteristics.

The technical objects of the embodiments are not limited to those described in this item and include those that may be understood through the description of the invention.

A display device including a semiconductor light-emitting device according to an embodiment may include a wiring substrate 150, a semiconductor light-emitting device 110 disposed on the wiring substrate 150, a diffusion layer 165 disposed on the semiconductor light-emitting device 110 and including a light scattering material 160, and a black layer structure 180 disposed on the diffusion layer 165 and including a transparent layer.

The black layer structure may include a first black layer structure disposed on the diffusion layer, and the first black layer structure may include one or more transparent layer between a plurality of black layers.

Also, the black layer structure may include a second black layer structure disposed on the diffusion layer. And the second black layer structure may include a first transparent layer, a second diffusion layer disposed on the first transparent layer, a second transparent layer disposed on the second diffusion layer and a black layer disposed on the second transparent layer.

The first black layer structure 180 including the transparent layer may include one or more transparent layers between a plurality of black layers.

The first black layer structure 180 including the transparent layer may include a first black layer 181a, a first transparent layer 182a disposed on the first black layer 181a, and a second black layer 181b disposed on the first transparent layer 182a.

The first black layer structure 180 including the transparent layer may include a second transparent layer 182b disposed on the second black layer 181b and a third black layer 181c disposed on the second transparent layer 182b.

The thickness T2E of the diffusion layer 165 on the upper side of the semiconductor light-emitting device 110 may be thinner than the thickness of the semiconductor light-emitting device 110.

The first black layer structure 180 including the transparent layer may be bonded by thermally compressed bonding without an adhesive layer on the diffusion layer 165.

In addition, a method of manufacturing a display device including a semiconductor light-emitting device according to an embodiment may include the steps of disposing a semiconductor light-emitting device 110 on a wiring substrate 150, a step of thermally compressed bonding the diffusion layer 165 including the light scattering material 160 on the semiconductor light-emitting device 110 in a semi-cured state, a step of thermally compressing the first black layer structure 180 including a transparent layer on the diffusion layer 165 in a semi-cured state and a curing process on the first black layer structure 180 including the diffusion layer 165 and the transparent layer.

The diffusion layer 165 may be thermally compressed and bonded to the wiring substrate on which the semiconductor light-emitting device is disposed in a semi-cured state without an adhesive layer.

Through the thermal compression process of the diffusion layer 165, the liquid material of the diffusion layer may fill a gap at a bottom of the semiconductor light-emitting device 110.

The first black layer structure 180 including the transparent layer may be bonded by thermally compressed bonding without an adhesive layer on the diffusion layer 165.

The first black layer structure 180 including the transparent layer may include one or more transparent layers between a plurality of black layers.

The first black layer structure 180 including the transparent layer may include a first black layer 181a, a first transparent layer 182a disposed on the first black layer 181a, and a second black layer 181b disposed on the first transparent layer 182a.

The first black layer structure 180 including the transparent layer may include a second transparent layer 182b disposed on the second black layer 181b and a third black layer 181c disposed on the second transparent layer 182b.

The thickness T2E of the diffusion layer 165 on the upper side of the semiconductor light-emitting device 110 may be thinner than the thickness of the semiconductor light-emitting device 110.

Additionally, a display device including a semiconductor light-emitting device according to an embodiment may include a wiring substrate 150, a semiconductor light-emitting device 110 disposed on the wiring substrate 150, a first diffusion layer 165 disposed on the semiconductor light-emitting device 110 and including a first light scattering material 160a and a second black layer structure 180B disposed on the first diffusion layer 165 and including a transparent layer and a diffusion layer.

The second black layer structure 180B may include a first transparent layer 182a, a second diffusion layer 166 disposed on the first transparent layer 182a, a second transparent layer 182b disposed on the second diffusion layer 166 and a black layer 181 disposed on the second transparent layer 182b.

In the second diffusion layer 166, the second light scattering material 160b is dispersed in a matrix, and the matrix may include at least one of epoxy-based, acrylic-based, silicone-based, or urethane-based.

The thickness from the upper side of the semiconductor light-emitting device 110 to the black layer 181 may be thinner than the thickness of the semiconductor light-emitting device 110.

The second black layer structure 180B including the transparent layer and the diffusion layer may be thermally compressed and bonded to the first diffusion layer 165 in a semi-cured state without an adhesive layer.

Also, according to an embodiment, a display device including a semiconductor light-emitting device may include a wiring substrate 150, a semiconductor light-emitting device 110 disposed on the wiring substrate 150, a transparent layer 182 disposed on the semiconductor light-emitting device 110 and a third black layer structure 180C disposed on the transparent layer 182 and including a diffusion layer.

The third black layer structure 180C may include the first diffusion layer 165a and the first black layer 181a disposed on the first diffusion layer 165a.

The third black layer structure 180C may include a second diffusion layer 165b disposed on the first black layer 181a and a second black layer 181b disposed on the second diffusion layer 165b.

The thickness from the top of the semiconductor light-emitting device 110 to the top of the third black layer structure 180C may be less than or equal to the thickness of the semiconductor light-emitting device 110. The third black layer structure 180C including the diffusion layer may be thermally compressed and bonded to the transparent layer 182 in a semi-cured state without an adhesive layer.

In the third black layer structure 180C, the first thickness Tb1 of the first black layer 181a disposed on the lower side may be thicker than the second thickness Tb2 of the second black layer 181b disposed on the upper side.

In the third black layer structure 180C, the first thickness Td1 of the first diffusion layer 165a disposed on the lower side may be thicker than the second thickness Td2 of the second diffusion layer 165b disposed on the upper side.

A display device including a semiconductor light-emitting device having a black layer structure with a light diffusion function according to an embodiment may provide a coating layer structure of the display device that can maintain or improve the black impression while improving color viewing angle characteristics.

For example, since the first embodiment may include the first black layer structure 180 having a transparent layer, the second thickness T2 of the diffusion layer 165 can be secured to be thin. In particular, the second-second thickness T2E of the diffusion layer 165 on the upper side of the semiconductor light-emitting device 110 may be secured to be thinner than the thickness of the semiconductor light-emitting device 110.

According to the first embodiment, the first black layer structure 180 including a transparent layer causes refraction at the interface of each layer to exert a scattering effect, thereby improving color viewing angle characteristics. In addition, by securing the second thickness T2 of the diffusion layer 165 to be thin, there is a complex technical effect of providing a coating layer structure of a display device that can maintain or improve the black impression by reducing the distribution of the scattering material 160.

Also, according to the first embodiment, the first black layer structure 180 including a transparent layer without a separate adhesive layer may be bonded by thermally compressed bonding on the diffusion layer 165. Accordingly, since the adhesive layer such as OCA may be omitted, there is a technical effect of increasing frontal luminance by improving light transmittance.

Also, according to the second embodiment, the second black layer structure 180B including a transparent layer and a diffusion layer causes refraction at the interface of each layer to exert a scattering effect, thereby improving color viewing angle characteristics. In addition, the distribution of scattering materials may be reduced by ensuring a thin third thickness T3 of the coating layer from the wiring board 150 to the black layer 181. Due to this, there is a complex technical effect that may provide a coating layer structure of a display device that can maintain or improve the black impression.

Also, according to the second embodiment, the second black layer structure 180B including a transparent layer and a diffusion layer may be thermally compressed and bonded on the first diffusion layer 165 without a separate adhesive layer. Accordingly, since the adhesive layer such as OCA may be omitted, there is a technical effect of increasing frontal luminance by improving light transmittance.

Also, according to the third embodiment, the third black layer structure 180C including a diffusion layer causes refraction at the interface of each layer to exert a scattering effect, thereby improving color viewing angle characteristics. In addition, the thickness of the coating layer from the wiring board 150 to the top of the third black layer structure 180C may be secured to be thin. Accordingly, there is a complex technical effect of providing a coating layer structure of a display device that can maintain or improve black impression by reducing the distribution of scattering materials.

In addition, according to the third embodiment, the third black layer structure 180C including a diffusion layer without a separate adhesive layer may be thermally compressed and bonded on the transparent layer 182 in a semi-cured state. Accordingly, since the adhesive layer such as OCA may be omitted, there is a technical effect of increasing frontal luminance by improving light transmittance.

Also, according to the third embodiment, when thermally compressed on the semiconductor light-emitting device 110, the first thickness Tb1 of the first black layer 181a disposed on the lower side may be controlled to be thicker than the second thickness Tb2 of the second black layer 181b disposed on the upper side. Accordingly, there is a technical effect of minimizing the change in black impression around the semiconductor light-emitting device 110 due to the step caused by the semiconductor light-emitting device 110.

Also, according to the third embodiment, when thermally compressed and bonded on the semiconductor light-emitting device 110, the first thickness Td1 of the first diffusion layer 165a disposed on the lower side may be controlled to be thicker than the second thickness Td2 of the second diffusion layer 165b disposed on the upper side. Accordingly, there is a technical effect of ensuring uniform scattering by minimizing changes in the distribution of the scattering material 160 around the semiconductor light-emitting device 110 due to the step caused by the semiconductor light-emitting device 110.

The technical effects of the embodiments are not limited to those described in this item and include those that may be understood through the description of the invention.

### BRIEF DESCRIPTION OF THE DRAWINGS

The accompanying drawings, which are incorporated herein and form part of the specification, illustrate various, non-limiting embodiments of the present invention. In the drawings, like reference numbers indicate identical or functionally similar elements.
FIG. 1 is an exemplary diagram of a display device 1000 including a semiconductor light-emitting device for display pixels according to an embodiment.
FIG. 2 is a perspective view of one of a plurality of display modules 200 included in the display device 1000 according to an embodiment.
FIG. 3 is a plan view of one display panel 210 included in the display module 200 according to an embodiment.
FIG. 4 is a cross-sectional view of the semiconductor light-emitting device package taken along line B 1-B 1' in the display panel 210 according to the embodiment shown in FIG. 3.
FIG. 5 is a cross-sectional view of a display device 210R including a semiconductor light-emitting device according to internal comparative technology.
FIG. 6 is a photograph of the coating layer 165 observed with an optical microscope in a display device 210R of comparative technology.
FIG. 7 is a cross-sectional view of the display device 210A according to the first embodiment.
FIGS. 8A to 8C are cross-sectional process diagrams of the manufacturing method of the display device 210A according to the first embodiment.
FIG. 9 is a cross-sectional view of the display device 210B according to the second embodiment.
FIGS. 10A and 10B are cross-sectional views of the display device 210C according to the third embodiment.

### DETAILED DESCRIPTION

Hereinafter, embodiments disclosed in this specification will be described in detail with reference to the attached drawings. The suffixes 'module' and 'part' for elements used in the following description are given or used interchangeably in consideration of ease of specification preparation, and do not have distinct meanings or roles in themselves. Additionally, the attached drawings are intended to facilitate easy understanding of the embodiments disclosed in this specification, and the technical idea disclosed in this specification is not limited by the attached drawings. Additionally, when an element such as a layer, region or substrate is referred to as being 'on' another element, this includes either directly on the other element or there may be other intermediate elements in between.

Display devices described in this specification may include a digital signage, a digital TV, a mobile phone, a smart phone, a laptop computer, a digital broadcasting terminal, a PDA (personal digital assistant), and a PMP (portable multimedia player), a navigation, a slate PC, a tablet PC, a Ultra-Book or a desktop computer, etc. However, the configuration according to the embodiment described in this specification may be applied to a display device even if it is a new product type that is developed in the future.

Hereinafter, a coating layer structure of a display device according to an example and a display device including the same will be described.

### (Embodiment)

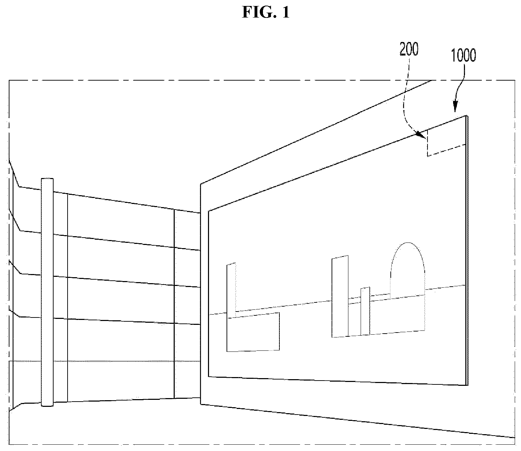

FIG. 1 is an exemplary diagram of a display device 1000 including a semiconductor light-emitting device for display pixels according to an embodiment. The display device 1000 according to the embodiment may include a plurality of assembled display modules 200.

The display device 1000 of the embodiment may be applied to digital signage. For example, FIG. 1 is an example of an indoor digital signage, but the display device 1000 of the embodiment may also be applied to an outdoor digital signage.

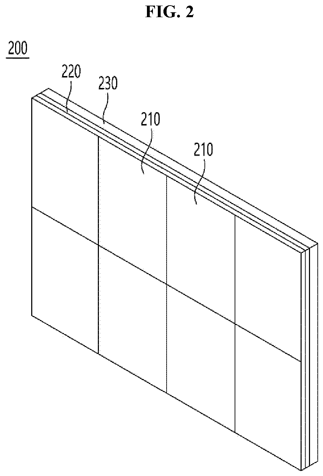

FIG. 2 is a perspective view of one of a plurality of display modules 200 included in the display device 1000 according to the embodiment.

The display module 200 shown in FIG. 2 may be mounted on each cabinet and assembled in a block manner to implement the display device 1000 of the embodiment.

The display module 200 of the embodiment may include a plurality of display panels 210 that output images, a module holder 220 on which the display panel 210 is placed, and a module cover disposed outside the module holder 220.

The plurality of display panels 210 may be arranged on the module holder 220 in a grid form to form one display module 200, and the individual display module 200 may be assembled into a predetermined cabinet shape to implement the display device 1000 according to the embodiment. Display data may be transmitted wired or wirelessly to the assembled individual display module 200.

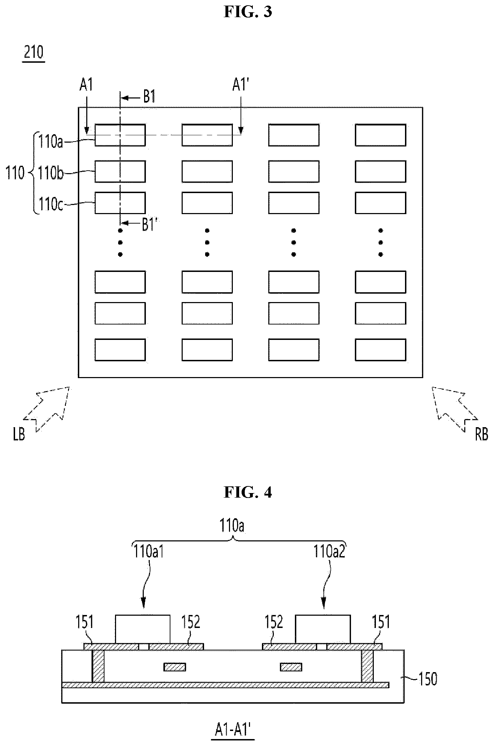

FIG. 3 is a plan view of one display panel 210 included in the display module 200 according to the embodiment.

Referring to FIG. 3, the display panel 210 according to the embodiment may include a semiconductor light-emitting device 110 for display pixels that implements each pixel.

For example, the semiconductor light-emitting device 110 for a display pixel according to the embodiment may include a first semiconductor light-emitting device 110a, a second semiconductor light-emitting device 110b, and a third semiconductor light-emitting device 110c, but it is not limited to this.

Each of the first to third semiconductor light-emitting devices 110a, 110b, and 110c may be repeatedly arranged to form individual subpixels. For example, the first to third semiconductor light-emitting devices 110a, 110b, and 110c may be a red light-emitting device, a green light-emitting device, and a blue light-emitting device, respectively, but are not limited thereto.

The first to third semiconductor light-emitting devices 110a, 110b, and 110c may have a size in micrometers (*µ*m). The micrometer (*µ*m) size may mean that a width of at least one of the light-emitting device is several to hundreds of *µ*m.

FIG. 4 is a cross-sectional view of the semiconductor light-emitting device package taken along line B1-B1' in the display panel 210 according to the embodiment shown in FIG. 3.

Referring to FIG. 4, each of the first to third semiconductor light-emitting devices 110a, 110b, and 110c may be disposed on the wiring substrate 150. FIG. 4 is a cross-sectional view of a semiconductor light-emitting device package in which adjacent first semiconductor light-emitting devices 110a are disposed on the wiring substrate 150.

For example, the first wiring 151 and the second wiring 152 may be disposed on the wiring substrate 150. The first wiring 151 may be a common wire that applies negative (-) power, and the second wiring 152 may be a wire that applies positive (+) power, but are not limited thereto.

The first semiconductor light-emitting device 110a may include a first-first semiconductor light-emitting device 110a1 and a first-second semiconductor light-emitting device 110a2 disposed adjacent to each other.

Each of the first-first semiconductor light-emitting device 110a1 and the first-second semiconductor light-emitting device 110a2 may be mounted on the first wiring 151 and the second wiring 152 in the form of a flip chip, but are not limited thereto.

According to the embodiment, the first-first semiconductor light-emitting device 110a1 and the first-second semiconductor light-emitting device 110a2 mounted on the first wiring 151 and the second wiring 152 may be arranged symmetrically.

For example, according to the embodiment, the second wire 152 that applies positive (+) power and the first wire 151 that applies negative (-) power may be arranged symmetrically to each other in adjacent subpixels.

In addition, the n electrode and p electrode of the first-first semiconductor light-emitting device 110a1 and the n electrode and p electrode of the first- second semiconductor light-emitting device mounted on each of the first wiring 151 and the second wiring 152 may be arranged symmetrically, but are not limited thereto.

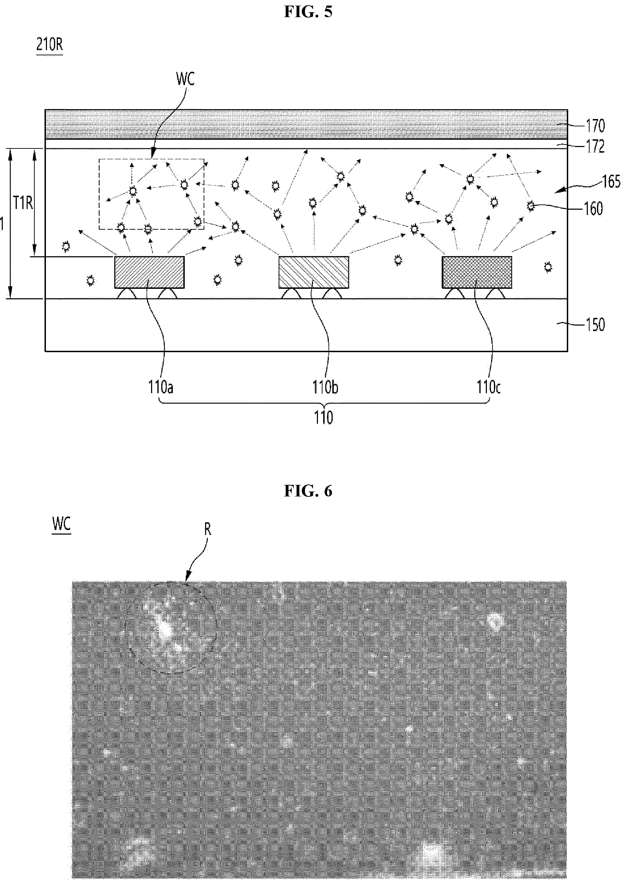

FIG. 5 is a cross-sectional view of the display device 210R including a semiconductor light-emitting device according to the internal comparative technology.

Referring to FIG. 5, the comparative technology 210R may include a wiring substrate 150, a semiconductor light-emitting device 110, a diffusion layer 165 including a light scattering material 160, and a black film layer 170. The semiconductor light-emitting device 110 may include first to third semiconductor light-emitting devices 110a, 110b, and 110c arranged on the wiring substrate 150 in a flip chip type.

FIG. 6 is a photograph of the diffusion layer 165 observed with an optical microscope in a display device 210R of comparative technology. For example, FIG. 6 may be a photograph of the first area WC of the display device 210R according to the comparative technology shown in FIG. 5, but is not limited thereto.

Referring to FIG. 6, when it is intended to improve color viewing angle characteristics by adding the light scattering material 160 in the diffusion layer 165, an agglomeration region R in which light scattering materials clump together may occur. When these light scattering materials clump together to form an agglomeration region (R), a cloudiness phenomenon occurs in which part of the coating layer appears white, and there is a problem in that the black impression is deteriorated.

Meanwhile, according to the comparative technology 210R, the black film layer 170 is disposed on the diffusion layer 165 to improve the black impression. The diffusion layer 165 of the comparative technology is formed through a curing process after liquid coating, and before the black film layer 170 is formed on the diffusion layer 165, a grinding process is performed on the cured diffusion layer 165 to a first thickness T1 to flatten the surface.

However, since the mechanical stress of the grinding process on the diffusion layer 165 may damage the semiconductor light-emitting device 110, there is a restriction in grinding the coating layer below the first-second thickness T1R.

In addition, in order to secure a color viewing angle, there is a restriction that the coating layer 160 in which the light scattering material 165 is dispersed on the upper side of the semiconductor light-emitting device 110 is to be remained at least a first-second thickness T1R that is more than twice the height of the semiconductor light-emitting device. Accordingly, due to the presence of the remained diffusion layer 165 of the first-second thickness T1R in which light scattering material 160 is dispersed on the upper side of the semiconductor light-emitting device 110, there is a problem that the black impression is deteriorated and the thickness of the display device is also increased.

Additionally, since the black film layer 170 of the comparative technology 210R has low adhesiveness, a separate adhesive layer 172 such as OCA is to be interposed between the diffusion layer 165 and the black film layer 170. But the adhesive layer 172, such as OCA, has a problem of deteriorating optical properties due to low optical transparency. In addition, the adhesive layer 172 has a high shrinkage/expansion property due to thermal changes, which reduces the reliability of the coating layer structure.

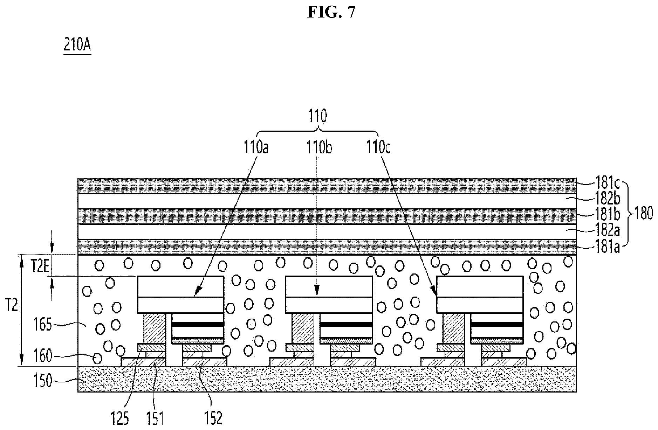

FIG. 7 is a cross-sectional view of the display device 210A according to the first embodiment.

Referring to FIG. 7, the display device 210A according to the first embodiment may include a wiring substrate 150, a semiconductor light-emitting device 110, a diffusion layer 165 including a light scattering material 160, and a first black layer structure 180 including a transparent layer. First and second wirings 151 and 152 may be formed on the wiring substrate 150, and bumps 125 may be formed on the semiconductor light-emitting device 110, but are not limited thereto.

The diffusion layer 165 may have a light scattering material 160 dispersed in a matrix, and the matrix may include an optical coating material such as epoxy-based, acrylic-based, silicon-based, or urethane-based, but is not limited thereto.

The light scattering material 160 may improve light efficiency by scattering light emitted from the semiconductor light-emitting device 110. The light scattering material 160 may have a size in nanometers The light scattering material 160 may include at least one of Zr, Si, Ti, Zn, BaS, or oxides thereof. Additionally, the content of the light scattering material 160 may be 0.01% to 30% of the matrix.

The surface of the light scattering material 160 may be hydrophobized. The light scattering material 160 undergoes a silylation reaction through surface treatment, and the surface may become hydrophobic. As the surface of the light scattering material 160 becomes hydrophobic, the light scattering materials may not clump together, and dispersibility within the coating layer can be improved. Accordingly, the embodiment has the technical effect of improving light uniformity according to area as the light scattering material 160 is uniformly distributed within the diffusion layer 165.

Meanwhile, in comparative technology, a black layer is adopted to improve the black impression. However, in comparative technology, there was no attempt to consider light scattering using a black layer other than a scattering agent.

On the other hand, the first black layer structure 180 including a transparent layer in the first embodiment may include at least one transparent layer between a plurality of black layers.

For example, the first black layer structure 180 having a transparent layer may include a first black layer 181a, a first transparent layer 182a disposed on the first black layer 181a, and a second black layer 181b disposed on the first transparent layer 182a. In addition, the first black layer structure 180 including the transparent layer may include a second transparent layer 182b disposed on the second black layer 181b and a third black layer 181c disposed on the second transparent layer 182b.

In the embodiment, the first to third black layers 181a, 181b, and 181c may include a pigment or dye that may produce a black color in the matrix. For example, the first to third black layers 181a, 181b, and 181c may include carbon black, acetylene black, etc., but are not limited thereto.

In the embodiment, the matrix of the first to third black layers 181a, 181b, and 181c may include a polymer material such as epoxy-based, acrylic-based, silicon-based, or urethane-based, but is not limited thereto.

The first black layer structure 180 having a transparent layer of the first embodiment may include a transparent layer between a plurality of black layers, and through this, refraction may occur at the interface of materials with different refractive indices, so refraction can occur at the interface of each layer, thereby demonstrating a scattering effect.

Accordingly, the first embodiment may secure the second thickness T2 of the diffusion layer 165 to be thin, and in particular, the second-second thickness T2E of the diffusion layer 165 on the upper side of the semiconductor light-emitting device 110 may be secured to be thinner than the thickness of the semiconductor light-emitting device 110.

Table 1 below shows black impression and color viewing angle data for the embodiments and comparative examples.

**[Table 1]**

| | Black impression | Color viewing angle (Δu'v' @±60° | Frontal luminance (nit) |
|---|---|---|---|
| Embodiment | 23.0 | 0.002/0.003 | 547 |
| Comparative example | 25.0 | 0.005/0.004 | 531 |

If the difference in black impression in the display device is more than about 0.3, it is a significant difference.

In the comparative example, the black impression was 25.0, the color viewing angle was 0.005/0.004 at ±60°, and the frontal luminance was 531 nit.

On the other hand, in the embodiment, the black impression was improved to 23.0, the color viewing angle was improved to 0.002/0.003 at ±60°, respectively, and the frontal luminance was also improved to 547 nits.

According to the first embodiment, the first black layer structure 180 including a transparent layer can cause refraction at the interface of each layer to exert a scattering effect, thereby improving color viewing angle characteristics. In addition, by ensuring that the second thickness T2 of the diffusion layer 165 is thin, the distribution of the scattering material 160 may be reduced, and thus there is a complex technical effect in that the black impression in the embodiment may be secured to 23.0, which is 2.0 more than the black impression of 25.0 in the comparative example.

Also, according to the first embodiment, the first black layer structure 180 including a transparent layer without a separate adhesive layer may be thermally compressed and bonded on the diffusion layer 165, so an adhesive layer such as OCA may be omitted. Therefore, there is a technical effect of increasing frontal luminance as light transmittance improves.

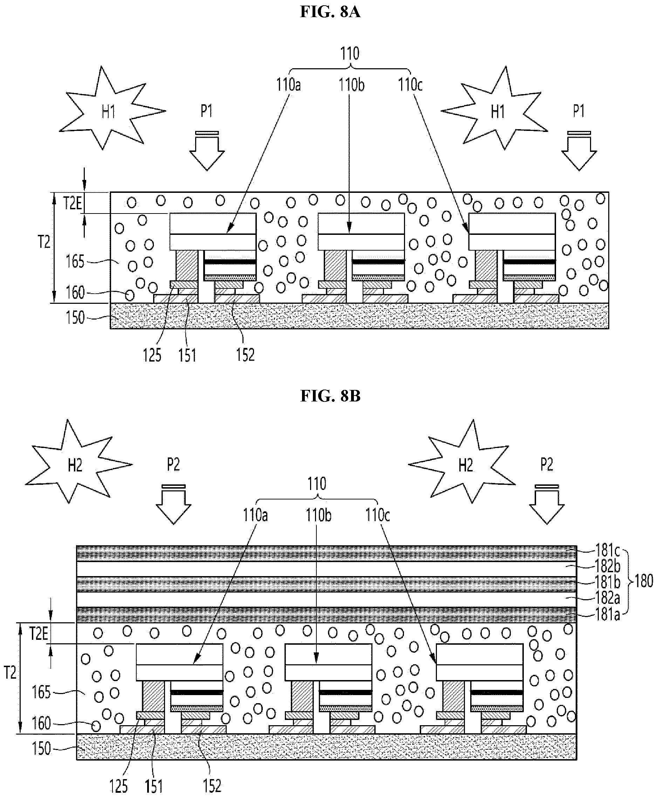

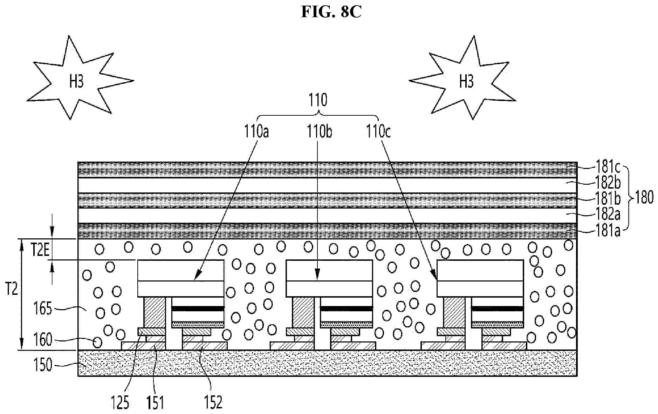

FIGs. 8Ato 8C are cross-sectional views of a process of manufacturing the display device 210A according to the first embodiment.

The display device 210A according to the first embodiment may be subjected to a curing process after thermal compression in a semi-cured state instead of the liquid coating and curing method of the comparative technology.

In FIGS. 8A to 8C below, it is explained that the first black layer structure 180 including the transparent layer laminated in a semi-cured state is subjected to a heat compression process of the diffusion layer 165 at one time, but the embodiment is not limited thereto. For example, in another embodiment a thermal compression process may be sequentially performed on the diffusion layer 165 while the first black layer 181a, the first transparent layer 182a, the second black layer 181b, the second transparent layer 182b and the third black layer 181c are in a semi-cured state.

Referring to FIG. 8A, the semiconductor light-emitting device 110 may be mounted on the wiring substrate 150.

Afterwards, the diffusion layer 165 including the light scattering material 160 is prepared in a semi-cured state and then the wiring substrate 150 on which the semiconductor light-emitting device 110 is mounted may be heated H1 to a first temperature and a first thermal compression process P1 may be performed at a first pressure.

The diffusion layer 165 may have a light scattering material 160 dispersed in a matrix, and the matrix may include an optical coating material such as epoxy-based, acrylic-based, silicon-based, or urethane-based, but is not limited thereto.

The first temperature may be a temperature range at which the diffusion layer 165 is melted, and the diffusion layer melted into a liquid phase may fill a bottom and sides of the semiconductor light-emitting device 110. In an embodiment, the liquid material of the diffusion layer 165 may fill a gap at the bottom of the semiconductor light-emitting device 110 by the thermal compression process of the diffusion layer 165, so that there may be no voids in the bottom of the semiconductor light-emitting device 110, thereby improving reliability.

The first embodiment may secure the second thickness T2 of the diffusion layer 165 thinner than the comparative technology, and in particular, the second-second thickness T2E of the diffusion layer 165 on the upper side of the semiconductor light-emitting device 110 may be secured to be thinner than the thickness of the semiconductor light-emitting device 110.

According to the first embodiment, there is a technical effect of maintaining or improving the black impression by reducing the distribution of the scattering material 160 by securing the second thickness T2 of the diffusion layer 165 to be thin.

Referring to FIG. 8b, after the thermal compression process of the diffusion layer 165, the first black layer structure 180, which includes a transparent layer laminated in a semi-cured state, may be heated to a second temperature H2 and a second heat compression process P2 may be performed at a second pressure.

The first black layer structure 180 including the transparent layer may include at least one transparent layer between a plurality of black layers. For example, the first black layer structure 180 including a transparent layer may include a first black layer 181a, a first transparent layer 182a disposed on the first black layer 181a, and a second black layer 181b disposed on the first transparent layer 182a. In addition, the first black layer structure 180 including the transparent layer may include a second transparent layer 182b disposed on the second black layer 181b and a third black layer 181c disposed on the second transparent layer 182b.

The matrix of the first to third black layers 181a, 181b, and 181c may include a polymer material such as epoxy-based, acrylic-based, silicon-based, or urethane-based, but is not limited thereto.

The first and second transparent layers 182a and 182b may include polymer materials such as epoxy-based, acrylic-based, silicon-based, and urethane-based, but are not limited thereto.

The second temperature may be a temperature range at which the first to third black layers 181a, 181b and 181c and the first to second transparent layers 182a and 182b melt or a range below. At the second temperature, the first to third black layers 181a, 181b, and 181c and the first to second transparent layers 182a and 182b, which are melted into a liquid state or in a semi-cured state, may be precisely bonded to the diffusion layer 165.

According to the first embodiment, the first black layer structure 180 having a transparent layer without a separate adhesive layer may be thermally compressed and bonded on the diffusion layer 165, so an adhesive layer such as OCA may be omitted such that there is a technical effect of increasing frontal luminance as light transmittance improves.

Referring to FIG. 8C, the first black layer structure 180 including the semi-cured diffusion layer 165 and the transparent layer may be cured by heating to a third temperature H3. The first black layer structure 180 having the transparent layer of the embodiment may include a transparent layer between a plurality of black layers, and through this, refraction occurs at the interface of materials with different refractive indices, so refraction may occur at the interface of each layer, thereby demonstrating a scattering effect.

According to the first embodiment, the first black layer structure 180 including a transparent layer may cause refraction at the interface of each layer to exert a scattering effect, thereby improving color viewing angle characteristics. In addition, by securing the second thickness T2 of the diffusion layer 165 to be thin, there is a complex technical effect of providing a coating layer structure of a display device that can maintain or improve the black impression by reducing the distribution of the scattering material 160.

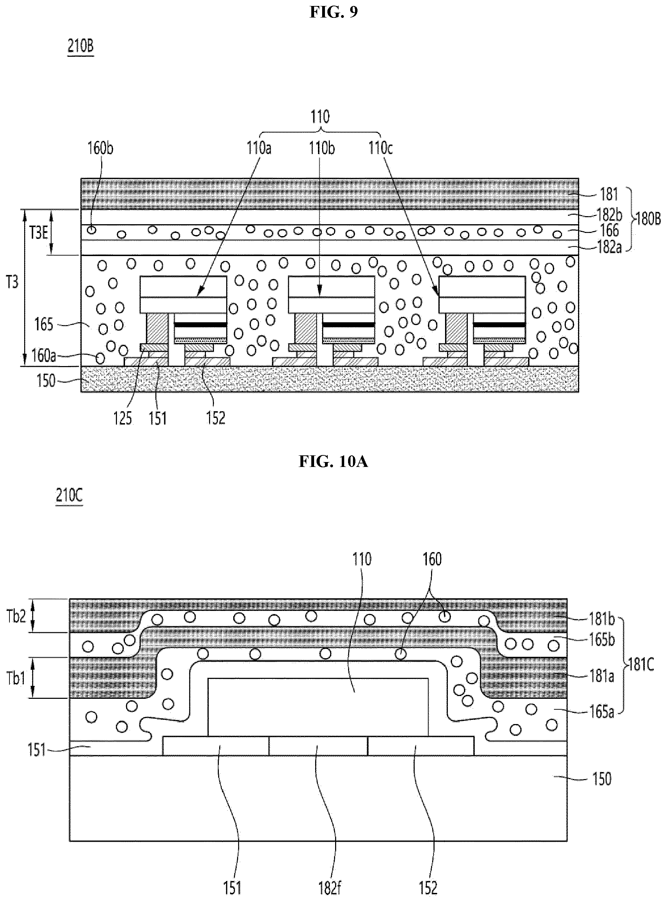

FIG. 9 is a cross-sectional view of the display device 210B according to the second embodiment.

The second embodiment may adopt the technical features of the first embodiment.

For example, the display device 210B according to the second embodiment may include a wiring substrate 150, a semiconductor light-emitting device 110, and a first diffusion layer 165 including a first light scattering material 160a.

The following description will focus on the main features of the second embodiment.

The second embodiment may include a second black layer structure 180B including a transparent layer and a diffusion layer on the first diffusion layer 165.

For example, the second black layer structure 180B may include a first transparent layer 182a, a second diffusion layer 166 disposed on the first transparent layer 182a, a second transparent layer 182b disposed on the second diffusion layer 166 and a black layer 181 disposed on the second transparent layer 182b.

The second diffusion layer 166 may have a second light scattering material 160b dispersed in a matrix, and the matrix may include, but is not limited to, an optical coating material such as epoxy-based, acrylic-based, silicone-based, or urethane-based.

The black layer 181 may contain a pigment or dye that may produce a black color in the matrix.

The second black layer structure 180B including a transparent layer and a diffusion layer of the second embodiment may include a diffusion layer between a plurality of transparent layers, through this, refraction occurs at the interface of materials with different refractive indices, so refraction occurs at the interface of each layer, thereby demonstrating a scattering effect.

Accordingly, the second embodiment may secure the third thickness T3 of the coating layer from the wiring substrate 150 to the black layer 181 to be thin, and in particular, the third-second thickness T3E from the upper side of the semiconductor light-emitting device 110 to the black layer 181 may be secured to be thinner than the thickness of the semiconductor light-emitting device 110.

According to the second embodiment, the second black layer structure 180B including a transparent layer and a diffusion layer causes refraction at the interface of each layer to exert a scattering effect, thereby improving color viewing angle characteristics. In addition, by ensuring a thin third thickness T3 of the coating layer from the wiring board 150 to the black layer 181, there is complex effects to provide a coating layer structure of a display device that can maintain or improve the black impression by reducing the distribution of scattering materials.

In addition, according to the second embodiment, the second black layer structure 180B including a transparent layer and a diffusion layer may be thermally compressed and bonded on the first diffusion layer 165 in a semi-cured state without a separate adhesive layer, since the adhesive layer such as OCA may be omitted, there is a technical effect of increasing frontal luminance by improving light transmittance.

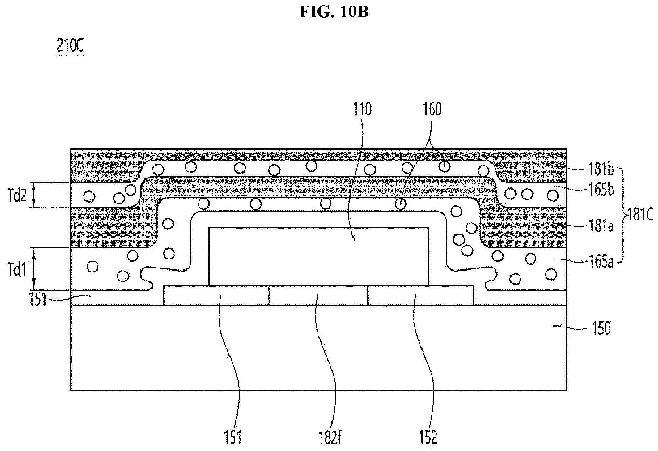

FIGs 10A and 10B are cross-sectional views of the display device 210C according to the third embodiment.

The third embodiment may adopt the technical features of the first or second embodiment.

For example, the display device 210C according to the third embodiment may include a wiring substrate 150 and a semiconductor light-emitting device 110.

The description below will focus on the main features of the third embodiment.

The third embodiment may include a third black layer structure 180C including a diffusion layer on the transparent layer.

For example, the third black layer structure 180C may include the first diffusion layer 165a and a first black layer 181a disposed on the first diffusion layer 165a. In addition, the third black layer structure 180C may include a second diffusion layer 165b disposed on the first black layer 181a and a second black layer 181b disposed on the second diffusion layer 165b.

The transparent layer may include an optical coating material such as epoxy-based, acrylic-based, silicon-based, or urethane-based, but is not limited thereto.

The first and second diffusion layers 165a and 165b may have a light scattering material 160 dispersed in a matrix, and the matrix may include an optical coating material such as epoxy-based, acrylic-based, silicon-based, or urethane-based, but it is not limited to thereto.

The first and second black layers 181a and 181b may contain a pigment or dye capable of producing a black color in the matrix, and the matrix may include, but is not limited to, an optical coating material such as epoxy-based, acrylic-based, silicone-based, or urethane-based.

The third black layer structure 180C including the diffusion layer of the third embodiment may include a diffusion layer between a plurality of black layers, and through this, refraction occurs at the interface of materials with different refractive indices, so refraction occurs at the interface of each layer, resulting in a higher scattering effect.

Accordingly, the third embodiment may ensure a thin coating layer from the wiring board 150 to the top of the third black layer structure 180C, in particular, the thickness from the top of the semiconductor light-emitting device 110 to the top of the third black layer structure 180C may be secured to be less than the thickness of the semiconductor light-emitting device 110.

According to the third embodiment, the third black layer structure 180C including the diffusion layer causes refraction at the interface of each layer to exert a scattering effect, thereby improving color viewing angle characteristics and ensuring a thin coating layer from the wiring board 150 to the top of the third black layer structure. Accordingly, there is a complex technical effect of providing a coating layer structure of a display device that can maintain or improve the black impression by reducing the distribution of scattering materials.

In addition, according to the third embodiment, the third black layer structure 180C including a diffusion layer without a separate adhesive layer may be thermally compressed and bonded on the transparent layer 182 in a semi-cured state, so that the adhesive layer such as OCA may be omitted, there is a technical effect of increasing frontal luminance by improving light transmittance.

Also, according to the third embodiment, the transparent layer 182 melted in a liquid state may be filled on the bottom and sides of the semiconductor light-emitting device 110. For example, the transparent layer may include a lower transparent layer 182f gap-filled between the bottom of the semiconductor light-emitting device 110 and the first and second wiring lines 151 and 152. In the third embodiment, the liquid material of the transparent layer is gap-filled to the bottom of the semiconductor light-emitting device 110 by the thermal compression process of the transparent layer, so that there are no voids on the bottom of the semiconductor light-emitting device 110, thereby improving reliability.

Also, referring to FIG. 10A, in the third black layer structure 180C, the first thickness Tb1 of the first black layer 181a disposed on the lower side may be thicker than the second thickness Tb2 of the second black layer 181b disposed on the upper side.

According to the third embodiment, when thermally compressed on the semiconductor light-emitting device 110, the first thickness Tb1 of the first black layer 181a disposed on the lower side is controlled to be thicker than the second thickness Tb2 of the second black layer 181b disposed on the upper side. Due to this, there is a technical effect of minimizing the change in black impression around the semiconductor light-emitting device 110 due to the step caused by the semiconductor light-emitting device 110.

Also, referring to FIG. 10b, in the third black layer structure 180C, the first thickness Td1 of the first diffusion layer 165a disposed on the lower side may be thicker than the second thickness Td2 of the second diffusion layer 165b disposed on the upper side.

According to the third embodiment, when thermally compressed on the semiconductor light-emitting device 110, the first thickness Td1 of the first diffusion layer 165a disposed on the lower side may be controlled to be thicker than the second thickness Td2 of the second diffusion layer 165b disposed on the upper side. Due to this, there is a technical effect of ensuring uniform scattering by minimizing changes in the distribution of the scattering material 160 around the semiconductor light-emitting device 110 due to the step caused by the semiconductor light-emitting device 110.

A display device including a semiconductor light-emitting device according to the embodiment may provide a coating layer structure of the display device that can maintain or improve the black impression while improving color viewing angle characteristics.

For example, the first embodiment may secure the second thickness T2 of the diffusion layer 165 to be thin, and in particular, the second-second thickness T2E of the diffusion layer 165 on the upper side of the semiconductor light-emitting device 110 may be secured to be thinner than the thickness of the semiconductor light-emitting device 110.

According to the first embodiment, the first black layer structure 180 with a transparent layer causes refraction at the interface of each layer to exert a scattering effect, thereby improving color viewing angle characteristics and ensuring a thin second thickness T2 of the diffusion layer 165. Accordingly, there is a complex technical effect of providing a coating layer structure of a display device that can maintain or improve the black impression by reducing the distribution of the scattering material 160.

Also, according to the first embodiment, the first black layer structure 180 including a transparent layer without a separate adhesive layer may be thermally compressed and bonded on the diffusion layer 165, so an adhesive layer such as OCA may be omitted. Therefore, there is a technical effect of increasing frontal luminance as light transmittance improves.

In addition, due to the second black layer structure including a transparent layer and a diffusion layer, refraction occurs at the interface of each layer to exert a scattering effect, thereby improving color viewing angle characteristics. Additionally, the third thickness T3 of the coating layer from the wiring board 150 to the black layer 181 may be secured to be thin. Accordingly, there is a complex technical effect of providing a coating layer structure of a display device that can maintain or improve black impression by reducing the distribution of scattering materials.

In addition, according to the second embodiment, the second black layer structure 180B including a transparent layer and a diffusion layer may be thermally compressed and bonded on the first diffusion layer 165 without a separate adhesive layer, so an adhesive layer such as OCA may be omitted, there is a technical effect of increasing frontal luminance by improving light transmittance.

In addition, according to the third embodiment, the third black layer structure 180C including a diffusion layer causes refraction at the interface of each layer to exert a scattering effect, thereby improving color viewing angle characteristics. In addition, the thickness of the coating layer from the wiring board 150 to the top of the third black layer structure 180C may be secured to be thin. Accordingly, there is a complex technical effect of providing a coating layer structure of a display device that can maintain or improve black impression by reducing the distribution of scattering materials.

In addition, according to the third embodiment, the third black layer structure 180C including a diffusion layer without a separate adhesive layer may be thermally compressed and bonded on the transparent layer 182 in a semi-cured state, so that the adhesive layer such as OCA may be omitted, there is a technical effect of increasing frontal luminance by improving light transmittance.

Also, according to the third embodiment, when thermally compressed on the semiconductor light-emitting device 110, the first thickness Tb1 of the first black layer 181a disposed on the lower side may be controlled to be thicker than the second thickness Tb2 of the second black layer 181b disposed on the upper side. As a result, there is a technical effect of minimizing the change in black impression around the semiconductor light-emitting device 110 due to the step caused by the semiconductor light-emitting device 110.

Also, according to the third embodiment, when thermally compressed on the semiconductor light-emitting device 110, the first thickness Td1 of the first diffusion layer 165a disposed on the lower side may be controlled to be thicker than the second thickness Td2 of the second diffusion layer 165b disposed on the upper side. Due to this, there is a technical effect of ensuring uniform scattering by minimizing changes in the distribution of the scattering material 160 around the semiconductor light-emitting device 110 due to the step caused by the semiconductor light-emitting device 110.

Although the present invention has been described above with reference to embodiments, those skilled in the art will easily understand that various modifications and changes may be made to the present invention without departing from the scope of the present invention as set forth in the claims below.

## Claims

1. A display device having a semiconductor light-emitting device (110) comprising:
a wiring substrate (150);
a semiconductor light-emitting device (110) disposed on the wiring substrate (150);
a diffusion layer (165) disposed on the semiconductor light-emitting device (110) and including a light scattering material; and
a black layer structure (180) disposed on the diffusion layer (165) and including a transparent layer (182).

2. The display device according to claim 1, where the black layer structure (180) comprises
a first black layer structure (180) disposed on the diffusion layer (165), wherein the first black layer structure (180) including the transparent layer (182) comprises one or more transparent layer (182) between a plurality of black layers (181a, 181b, 181c).

3. The display device according to claim 2, the first black layer structure (180) including the transparent layer (182) comprising:
a first black layer (181a);
a first transparent layer (182a) disposed on the first black layer (181a); and
a second black layer (181b) disposed on the first transparent layer (182a).

4. The display device according to claim 3, wherein the first black layer structure (180) including the transparent layer (182) further comprising:
a second transparent layer (182b) disposed on the second black layer (181b) and
a third black layer (181c) disposed on the second transparent layer (182b).

5. The display device according to any one of claims 1 to 4, wherein a thickness of the diffusion layer (165) above the semiconductor light-emitting device (110) is thinner than a thickness of the semiconductor light-emitting device (110).

6. The display device according to any one of claims 2 to 5, wherein the first black layer structure (180) including the transparent layer (182) is thermally compressed and bonded without an adhesive layer (172) on the diffusion layer (165).

7. The display device according to claim 1, where the black layer structure (180) comprises a second black layer structure (180B) disposed on the diffusion layer (165), and
wherein the second black layer structure (180B) comprises:
a first transparent layer (182a);
a second diffusion layer (165b) disposed on the first transparent layer (182a);
a second transparent layer (182b) disposed on the second diffusion layer (165b); and
a black layer (181) disposed on the second transparent layer (182b).

8. The display device according to claim 7, wherein the second diffusion layer (165b) has a second light scattering material (160b) dispersed in a matrix, and the matrix comprises at least one of epoxy-based, acrylic-based, silicone-based, or urethane-based.

9. The display device according to claim 7 or 8, wherein a thickness (T2E) from an upper side of the semiconductor light-emitting device (110) to the black layer (181) is thinner than a thickness of the semiconductor light-emitting device (110).

10. The display device according to claim 7, wherein the second black layer structure (180B) including the transparent layer (182) and the diffusion layer is thermally compressed and bonded on a first diffusion layer (165) in a semi-cured state without an adhesive layer (172).

11. A manufacturing method for a display device having a semiconductor light-emitting device (110), comprising:
disposing the semiconductor light-emitting device (110) on a wiring substrate (150);
thermally compressing a diffusion layer (165) provided with a light scattering material on the semiconductor light-emitting device (110) in a semi-cured state;
thermally compressing a black layer structure (180) including a transparent layer (182) on the diffusion layer (165) in a semi-cured state; and
performing a curing process on the black layer structure (180) including the diffusion layer (165) and the transparent layer (182).

12. The manufacturing method for display device according to claim 11 wherein the diffusion layer (165) is thermally compressed and bonded in the semi-cured state without an adhesive layer (172) on the wiring substrate (150) on which the semiconductor light-emitting device (110) is disposed.

13. The manufacturing method for display device according to claim 11, wherein a liquid material of the diffusion layer (165) is configured to fill a gap at a bottom of the semiconductor light-emitting device (110) by the thermal compression process of the diffusion layer (165).

14. The manufacturing method for display device according to claim 11, where the black layer structure (180) comprises a first black layer structure (180) disposed on the diffusion layer (165), wherein the first black layer structure (180) including the transparent layer (182) comprises one or more transparent layer (182) between a plurality of black layers (181a, 181b, 181b).

15. The manufacturing method for display device according to claim 14, wherein the first black layer structure (180) including the transparent layer (182) comprising:
a first black layer (181a);
a first transparent layer (182a) disposed on the first black layer (181a); and
a second black layer (181b) disposed on the first transparent layer (182a).
